Europäisches Patentamt

European Patent Office

Office européen des brevets

(19)

(11) EP 1 422 862 A2

(12) **EUROPEAN PATENT APPLICATION**

(43) Date of publication:
26.05.2004 Bulletin 2004/22

(51) Int Cl.⁷: **H04L 1/20**, H04L 1/00

(21) Application number: 03257292.7

(22) Date of filing: 19.11.2003

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **19.11.2002 GB 0227017**

(71) Applicant: **Matsushita Electric Industrial Co., Ltd.**
**Kadoma-shi, Osaka-fu 571-8501 (JP)**

(72) Inventor: **Lijofi, Laolu**
**Harlesden, London NW10 4PJ (GB)**

(74) Representative: **Dawson, Elizabeth Ann et al**
**A.A. Thornton & Co.**
**235 High Holborn**
**London WC1V 7LE (GB)**

(54) **Bit error rate estimator**

(57) In a digital communications channel, an intitial estimate of bit error rate is obtained, compared with a threshold value and modified as necessary depending on decision criteria involving the threshold. Preferably the modification involves using soft decision information from a channel decoder.

FIGURE 2

**Description**

## FIELD OF THE INVENTION

The present invention relates to the estimation of bit error rate (BER) in general and signal quality measurement in particular, in communications channels. The invention has been designed for mobile telecommunications channels but may have more general applications.

## BACKGROUND OF THE INVENTION

According to the GSM standard 05.08 [1], the received signal quality, RXQUAL will be used as criterion for RF power control and handover process. In other words, it is necessary that the received signal quality be accurately estimated in order to ensure that the most appropriate radio frequency (RF) decisions on power control and hand-over are made. Thus, in mobile wireless communication, to reduce co-channel and adjacent channel interference and also to conserve mobile station battery life, mobile station and base station adjust their transmit powers accordingly based on received signal quality measurements. This implies that when channel conditions are good, transmitted power is reduced and vice-versa.

Several techniques exist to estimate bit error rate:

One such method involves estimating the signal to noise ratio (SNR) which is mapped to a BER or signal quality band. At low SNR values, this technique yields poor performance

Another scheme estimates channel BER by 'pseudober' measurement or 're-enocde and compare' technique. BER is estimated by encoding the channel decoder output and comparing with demodulated/equalised bits. BER is obtained by calculating the number of corrected bits. Although this method provides a good signal quality estimate, it is computationally intense.

US patent 5944844 discloses a method for determining connection quality in a cellular system. In this method, received signals are decoded with a Viterbi decoder and decision variables are converted into a float value format. During traceback of the Viterbi trellis, the sum of the absolute values of stored decision variables and minimum value of the decision variables in the traceback (or correct) path are calculated. The sum of the absolute values is averaged over a desired measurement period and compared to a predetermined threshold to obtain a BER over the connection.

US patent 6163571 discloses a method for measuring received signal quality by obtaining an initial estimate using the re-encode and compare scheme. Bias in the initial estimate of the channel bit error rate is removed to produce a refined estimate of the channel bit error.

These and other known methods are either computationally intense (i.e. increased computational complexity) and/or require considerable memory storage in measurement device and/or provide poor estimates in poor channel conditions.

## SUMMARY OF THE INVENTION

This invention provides a method for estimating received signal quality or bit error rate (in terms of number of errors per burst) in a digital system. This is achieved by obtaining an initial estimate of signal quality, preferably using the merit of decisions (soft decisions) of the demodulator/equaliser. The estimate is compared with a threshold and based on some criteria, this initial estimate is refined.

In the preferred embodiment of the invention, the bias in this initial BER estimate is removed and the estimate refined by utilising soft information obtained from the channel decoder. The soft information obtained from the channel decoder is a metric value representing the minimum distance (or maximum cross-correlation) between the sequence represented by the path and the received sequence. The metric value represents information about the possible number of corrected errors performed by the decoder given the received sequence. The estimate of the number of errors is adjusted according to some defined criteria using the metric value from the decoder.

The initial bit error rate or signal quality estimate is preferably obtained by averaging the estimated number of errors per burst over a desired measurement period. Averaging over sub-intervals of a measurement period tends to be more accurate since estimation errors in the different sub-intervals are averaged out.

The invention aims to provide a method of BER estimation that is not computationally complex and that is not "memory storage hungry".

The estimate finally obtained using the invention may be mapped to a signal quality (or RXQUAL) band. Here, the objective is not to make the estimate of BER precisely accurate but sufficiently accurate to allow correct mapping of the received signal to an appropriate signal quality band.

**BRIEF DESCRIPTION OF THE DRAWINGS**

An embodiment of the invention will now be described by way of example only and with reference to the accompanying drawings in which:

Figure 1 shows a block diagram of a communication system that may use the present invention; and
Figure 2 shows a block diagram of a system for estimating 'n_err' using soft data only.

**DETAILED DESCRIPTION OF THE INVENTION**

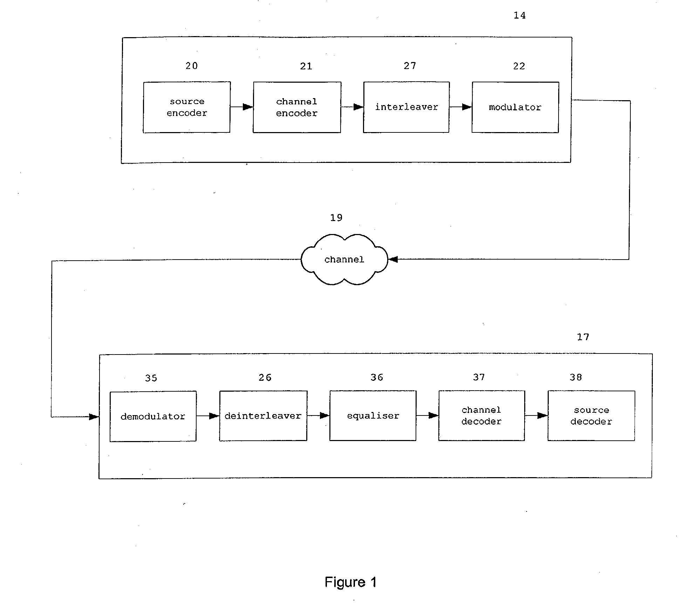

Figure 1 describes in block diagram, by way of example, a digital communication system that may use this invention. The communication system comprises a transmitting terminal, 14 and a receiving terminal, 17. The transmitter, 14, communicates with the receiver, 17, over a channel, 19. The transmitter usually consists of a source encoder, 20, channel encoder, 21 and a modulator, 22. The source encoder, 20, transforms the source information into a format required by the channel encoder. The channel encoder 21, provides some error protection by adding some redundancy to the information bit sequence. To transmit over the channel, the channel encoder output modulates an analog waveform in the modulator 22. The modulated waveform is transmitted over the channel.
At the receiving terminal, 17, the received signal is passed to the demodulator, 35, which transforms the received waveform into a discrete-time signal. The output of 35 is passed to an equaliser, 36, which attempt to remove inter-symbol interference in the demodulated output. The equaliser, 36, outputs soft decisions (i.e. soft measurement of received bit confidence) that is used by the decoder, 37, to estimate the source-coded information. The decoder output is applied to the source decoder, 38, which transform the signal to an appropriate format for the terminal host.
The method to be described below uses the soft decisions obtained from the equaliser (or demodulator) and metric value obtained from channel decoder to provide an estimate of the number of errors in a received frame. The estimated number of frames is averaged over a desired measurement period. This average provides the estimated BER.

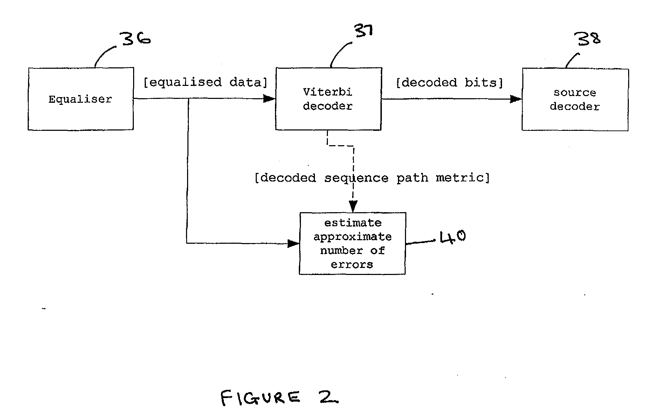

Figure 2 illustrates how the approximate number of errors is obtained. In figure 2 the channel decoder 37 is a viterbi decoder. The estimate n-err is obtained using soft data from the equaliser and, as shown by the dotted line, a metric valve obtained from the viterbi decoder 37. The estimate is calculated in block 40.

**Estimating '*n err*' using equalised soft bits**

Since the equalised soft-data provide a soft measurement of bit decision confidence, given a received block (or frame) of 'N' soft-decision data it is possible to estimate the error probability for the $i^{th}$ bit, $P_{e,i}$, as

$$P_{e,i} = \frac{1}{1+e^{\lambda|S_i|}} \quad ;1 \leq i \leq N \tag{1}$$

where
$|S_i|$ is the magnitude of the soft - data and
$\lambda$ is a positive constant
Another approximation for the bit error probability can be given by

$$P_{e,i} \cong \frac{\beta}{1+2^{\alpha|S_i|}} \quad ;1 \leq i \leq N \tag{2}$$

where
$\alpha$ and $\beta$ are positive constants
The values of $\lambda$, $\alpha$ and $\beta$ are empirically obtained in a type testing measurement (or simulation environment) in which known bit streams are sent through various propagation media at different SNR and channel condition. The actual BER obtained are used to set $\lambda$, $\alpha$ and $\beta$ appropriately.
It can be assumed that bit errors are independent due to the de-interleaving operation in the receiver, therefore the expected number of errors within a block can be approximated, from equation (2), as

$$n\_err \cong \sum_{i=1}^{N} P_{e,i} \quad ;1 \le i \le N$$

$$n\_err \cong \sum_{i=1}^{N} \frac{\beta}{1+2^{\alpha|S_i|}} \quad ;1 \le i \le N \tag{3}$$

Figure 2 illustrates how the approximate number of errors is obtained.

It can be seen that this initial estimate of number of errors can be biased (depending on the values of the empirical constants). For example, it might be desired that estimation accuracy is higher at low SNR (or poor channel quality) than at good channel conditions. Hence $\lambda$ or $\alpha$ and $\beta$ can be adjusted accordingly.

The description continues with the assumption that the n_err estimation (invariably the selection of $\lambda$ or $\alpha$ and $\beta$) in (2) or (3) is biased in favour of obtaining higher estimation accuracy in poor channel conditions.

Thus, to improve the accuracy of estimation at high SNR channel conditions, soft-information from the channel decoder (Viterbi decoder), in form of the "decoded-sequence path metric value", is used by this estimator to refine the per frame BER estimation. The "decoded-sequence state path metric value", (PM) value refers to the path metric value of the maximum likelihood path (i.e. path of decoded bit sequence).

The path metric for a path, at time instant, n, is the sum of the branch metrics along this path. The branch metric, at a time instant, n, for a given path is defined as the Euclidean distance (or cross correlation) between the equalised soft decisions and the expected transmitted bits. It could also be defined as the joint probability of the received symbol conditioned on the estimated transmitted symbol.

Assuming branch metric is calculated as the cross-correlation of the received equalised soft decision data and the expected transmitted bits,

let

PM = decoded - sequence path metric (= sum of branch metric on decoded sequence path)

$S_{ave}$ = average magnitude of equalised soft decisions =

$$\sum_{i=1}^{N} \frac{|S_i|}{N}$$

$S_{total}$ = sum of magnitude of equalised soft data =

$$\sum_{i=1}^{N} |S_i|$$

Given a set of 'M' thresholds $T_1$, $T_2$..$T_M$ corresponding to a set of M constants $C_1$, $C_2$..$C_M$.

Using the following pseudo-code, estimation improvement can be obtained.

- *Calculate difference ($S_{total}$ - PM). This is the difference between maximum path metric value achievable with current soft data and actual path metric value returned from Viterbi decoder. It provides an indication of the number of errors in the received sequence.*

- *Calculate*

$$U_{test} = \mu\left(\frac{S_{total} - PM}{S_{ave}}\right) - n\_err$$

- *If $U_{test} > T_i \; \varnothing i = 1, 2,... M$, then*

  - *$n\_err = n\_err + C_i$*

- *else*

  - *n_err = n_err*

This method of BER estimates directly estimates the per-frame or per-block number of errors, using the magnitude of the equalised soft data, and provides estimation improvement by using soft information contained in the Viterbi decoder trellis final metric value. In tests this technique has been found to provide good results whilst being less computationally expensive than that disclosed in [1].

**REFERENCE**

[1] TS05.08 v8.13.0 3rd Generation Partnership Project; Radio subsystem link control (Release 99).
[2] J. Hagenauer, P. Hoeher, "A Viterbi algorith with soft-decision outputs and its applications", Proc. GlobeCom 89, pp. 47.1.1.-47.1.7

**Claims**

1. A method of estimating the number of errors in a block of signals received over a digital communications channel, the method comprising:

   a) calculating an approximate number of errors n_err within the block using a set of empirical values.
   b) comparing n_err with a threshold value,
   c) if n_err satisfies decision criteria involving said comparison in step (b) accepting n_err as an estimate of number of errors perframe,
   d) if n_err does not satisfy decision criteria in (c), modifying n_err on the basis of empirical values to provide an estimate of the bit error rate.

2. A method as claimed in claim 1 in which n_err is calculated by averaging calculated approximations of number of errors over a desired measurement period.

3. A method as claim in claim 1 or 2 in which following step (d) the estimate of per block number of errors is averaged over a measurement period and the average estimate is mapped to to a signal quality band.

4. A method as claimed in claim 1, 2 or 3 applied to a communications channel in which received data is processed to provide bit decision confidence, and in which n_err is determined on the basis of said bit decision confidence data.

5. A method as claimed in claim 4 in which n_err is claculated as

$$n\_err \cong \sum_{i=1}^{N} P_{e,i} \quad ; 1 \leq i \leq N$$

where $P_{e,i}$ is the error probability for the $i^{th}$ bit and $N$ is the total number of bits in the block.

6. A method as claimed in claim 5 in which $P_{e,i}$ is calculated as

$$P_{e,i} = \frac{1}{1 + e^{\lambda |S_i|}} \quad ; 1 \leq i \leq N$$

   where

   $|S_i|$ is the magnitude of data representing bit decision confidence and
   $\lambda$ is a positive constant

**7.** A method as claimed in claim 5 in which

$$P_{e,i} \cong \frac{\beta}{1+2^{\alpha|S_i|}} \;;1 \leq i \leq N$$

where Si is the magnitude of data representing bit decision confidence and $\alpha$ and $\beta$ are constants.

**8.** A method as claimed in any of claims 2 to 7 in which during step (d) the sum of the magnitudes of the soft data values of the block ($S_{total}$) is compared to the average magnitude ($S_{ave}$), and the approximate number of errors is adjusted by an amount depending on the comparison.

**9.** A method according to claim 8 in which a parameter related to $S_{total}$ is compared to a plurality of thresholds and n_err is modified according to decision criteria involving said plurality of thresholds.

**10.** A method according to claim 9 in which n_err is increased by an integer value according to which threshold criteria is satisfied.

**11.** A method according to claim 8 in which the parameter related to $S_{total}$ is the ratio of ($S_{total}$ - PM) to $S_{ave}$ which is compared to a number of thresholds and n_err is modified according to decision criteria.

**12.** A method as claimed in claim 9 or 10 which the parameter related to $S_{total}$ is ($S_{total}$ - PM) $\mu$ where $\mu$ is a constant determined empirically and PM is a parameter representing quality of decoding decision

**13.** A method as claimed in any of claims 9 to 12 in which the difference ($S_{total}$ - PM) represents channel quality.

**14.** A method as claimed in claim 11 or 12 in which the data is decoded by a Viterbi decoder and PM is the path metric of the decoded sequence.

**15.** A method as claimed in any of claims 9 to 14 in which the thresholds include $S_{ave}$ n_err and Save (n_err+j) where j is an integer.

Figure 1

FIGURE 2